Europäisches Patentamt

(19) European Patent Office

Office européen des brevets

(11) Publication number: **0 452 006 A2**

# (12) EUROPEAN PATENT APPLICATION

(21) Application number: **91302786.8**

(22) Date of filing: **28.03.91**

(51) Int. Cl.⁵: **C23C 16/44**, C23C 16/50,
C23C 16/30

(30) Priority: **30.03.90 JP 80691/90**
**27.11.90 JP 320689/90**

(43) Date of publication of application:
**16.10.91 Bulletin 91/42**

(84) Designated Contracting States:
**DE FR GB**

(71) Applicant: **Ogura, Atsushi**
**2-14-30, Yukinoshita**
**Kamakura Kanagawa 248 (JP)**

(72) Inventor: **Ogura, Atsushi**
**2-14-30, Yukinoshita**
**Kamakura Kanagawa 248 (JP)**

(74) Representative: **Jump, Timothy John Simon et**
**al**
**VENNER, SHIPLEY & CO. 368 City Road**
**London EC1V 2QA (GB)**

(54) A composite film and method of manufacturing the same.

(57)    A method of forming on a substrate (11) a composite film (3) comprising two or more elements, wherein matter (6,8) containing film forming elements is carried into a gaseous plasma (5), where said matter is converted into a vapour state (12) and is conveyed towards the substrate (11), to form thereon a composite film (3), having a desired combination and distribution of said elements.

EP 0 452 006 A2

Fig 1

The present invention relates to a method of forming, by vapour deposition on a substrate, a composite film comprising two or more different elements and to a composite film so produced.

Conventional vapour deposition techniques include those where a vapour of the film forming material is produced by heating and evaporating said material and those where the vapour of film forming material is formed by sputtering. To form a film by the first of these methods, the film forming material is heated in a high temperature furnace and caused to evaporate into a chamber, in which a substrate is located. The substrate is usually maintained at a lowered temperature, so that the film forming material will condense to form the desired film on the substrate.

Sputtering is generally used to form a thin film of a metallic substance. In this technique, the metallic substance forms a cathode which, together with a substrate, is placed in an atmosphere of an inert gas (usually argon). The gas is then ionized, generally by a radio frequency electric discharge, and positively charged ions of the gas are caused to impact upon the cathode, ejecting atoms of the metallic substance to form a vapour. Material from this vapour then condenses on the substrate, which is normally maintained at a lowered temperature, to form the desired thin film.

Attempts to use either of these two methods to form multi-component or composite films, of uniform composition and consistency, to date have proven unsuccessful. Since many substances have differing vapour pressures, boiling points, or sublimation points it is difficult to form a vapour comprised of several substances, in the relative amounts required in order to form a composite film comprising pre-selected elements in a predetermined ratio. In fact, if the vapour is to be generated by the action of heat alone, the elements required to make up a particular multi-element film generally have to be evaporated and deposited one at a time and, accordingly, it is impossible to manufacture a composite film, in which the constituent elements are uniformly or homogeneously distributed by this method.

In practice, sputtering is limited in application to the formation of films from a layer or layers of metallic substances and can only be used to deposit one element at a time. Thus, although multilayer films, wherein each layer is comprised of a different element, can be formed by this technique, a multi-component composite film, in which the constituent elements are uniformly and homogeneously distributed, cannot be so formed.

Both of the aforementioned techniques, in practice, are generally only employed to form thin films of metallic substances and are not used to form films which include non-metallic elements, or compounds thereof. In particular, films which include oxygen compounds have not been made using their vapour deposition techniques.

An object of the present invention is to provide a multi-element, or composite film, formed by vapour deposition, which includes at least two different elements, distributed substantially uniformly as discrete molecules, a mixture of atoms or ions, an alloy, or as an extended array of atoms or ions. A further object of the present invention is to provide a method of manufacturing such a film.

According to a first aspect of the present invention there is provided a method of forming on a substrate a composite film comprising two or more elements, wherein matter containing film forming elements is carried into a gaseous plasma, where said matter is converted into a vapour state, and is conveyed towards the substrate, to form the composite film thereon. The method of the invention allows the formation of multi-element films having a desired combination and distribution of said elements. By employing the method of the present invention, a multi-component composite film can be obtained, in which the film forming elements are uniformly distributed at an atomic, or molecular level. The nature, distribution and ratios of the atoms, ions or radicals, in which the film forming elements are arranged in the film, may be altered and determined by making corresponding adjustments to the composition of the starting matter, carried into the gaseous plasma. Accordingly, it is possible to obtain a film in the form of a homogeneous solid solution of several substances, including non-metallic elements such as oxygen. Ceramic films may also be formed using the inventive method.

Preferably, the matter carried into the gaseous plasma is converted into an ionized, or partially ionized vapour state in the gaseous plasma. The matter may comprise fine solid or liquid, preferably solid, particles, which are suspended in a gaseous substance for being conveyed into the plasma. Said gaseous substance may also provide film forming elements.

In an embodiment, the gaseous plasma is formed from an inert gas, such as helium or argon, preferably in admixture with ammonia, oxygen, or hydrogen. The plasma can be inductively generated by passing an oscillating, preferably radio frequency, electric field through the gas. In a preferred embodiment, the radio frequency electric field is applied to the plasma forming gas by a coil arranged around a plasma containing vessel.

In a preferred arrangement, the film forming elements are deposited on the substrate, in proportion to their presence in the matter. The ions or radicals present in the matter may be preserved in the film after formation. Preferably, the components and elements forming the matter are selected so that the film is formed as a solid solution, comprising a uniform distribution of its constituent elements. Thus, the film can include individual molecules or ions, and may comprise a crystalline or other extended array of elements, or ions.

In a preferred embodiment, the substrate is maintained at a lower temperature than the gaseous plasma and the gaseous plasma and substrate are retained in conditions of reduced pressure.

The matter can be comprised of metals, non-metals or semi-metallic elements. Preferably the matter includes elements selected from iron, nickel, aluminium, chromium, oxygen, nitrogen, hydrogen, arsenic, antimony, bismuth, selenium, tellurium, silicon, germanium, carbon and boron. These elements may be present in the form of oxides, nitrates, carbides, and ammonium compounds. In a preferred embodiment, in which the matter in the form of fine solid or liquid particles is suspended in a gaseous substance, the gaseous substance includes hydrocarbon, preferably methane and the resulting composite film includes a carbide. The carbon in said carbide being provided by the hydrocarbon or methan.

Where the matter includes fine solid particles, these particles preferably are produced by reacting an aqueous solution of a salt or salts, including at least two or more ions in addition to those from the water, with an alkali, such as caustic soda or aqueous ammonia to precipitate the corresponding oxide, oxides, hydroxides or hydrated oxides. The oxygen containing compounds so formed are dried, after removal of the remaining salt solution and comminuted to provide a powder of suitably sized particles. Preferably, the aqueous salt solution is a metal halide, most preferably a metal chloride.

In a preferred embodiment, the matter including the film forming elements is heated by laser light, prior to entering the electric field.

Preferred embodiments of the first aspect of the invention are described in claims 2-16 and 25-33.

In a second aspect, the present invention provides a thin film comprising two or more elements carried on a substrate, wherein said elements are substantially regularly distributed in the film in predetermined proportions. Advantageously, the elements and their proportions in the film, may be selected so that the film has the physical properties required for its intended use. The film may be physically strong, tough and resistant to deterioration and can be suitable for use as a storage element. Thus the film may be a magnetic thin film, a light reactive magnetic thin film, or a film for use in various types of sensors, such as an oxide thin film.

Preferably, the elements forming the film include at least one non-metallic element. More preferably the elements forming the film are selected from iron, nickel, aluminium, chromium, oxygen, nitrogen, arsenic, antimony, bismuth, selenium, tellurium, silicon, germanium, boron and hydrogen. The film is preferably a solid solution or may include individual molecules or ions, may be in the form of an extended array or have a rigid crystalline structure.

In a most preferred embodiment, the film is a ceramic film and is formed in accordance with the method of the first aspect of the present invention.

Preferred embodiments of the second aspect of the invention are described in claims 18-24.

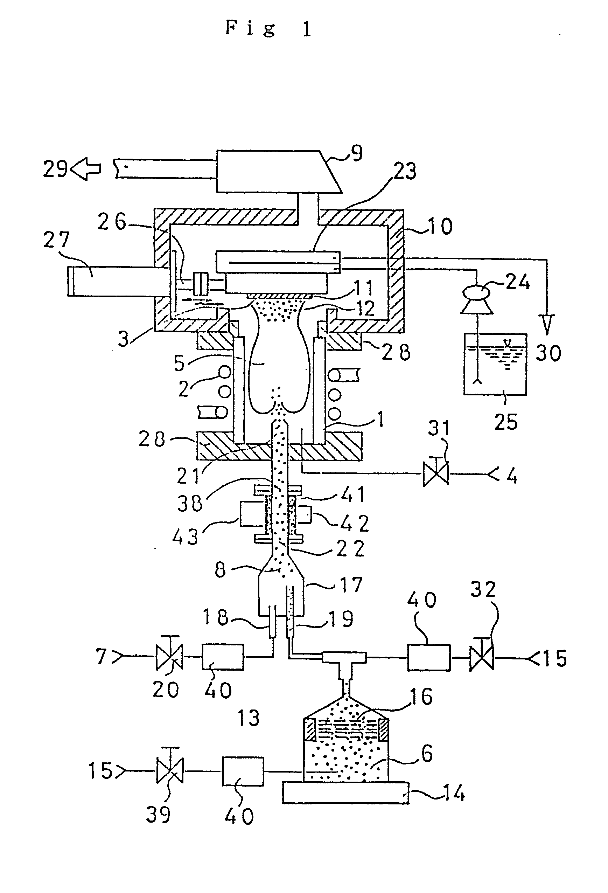

Figures 1, 2 and 3 show three different forms of apparatus which may be employed for carrying out the method of the present invention.

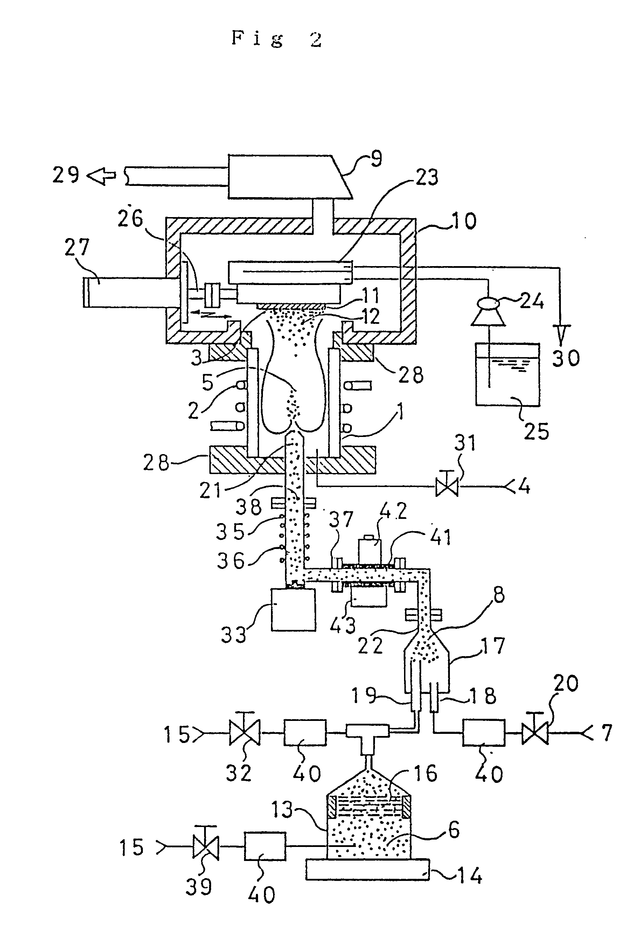

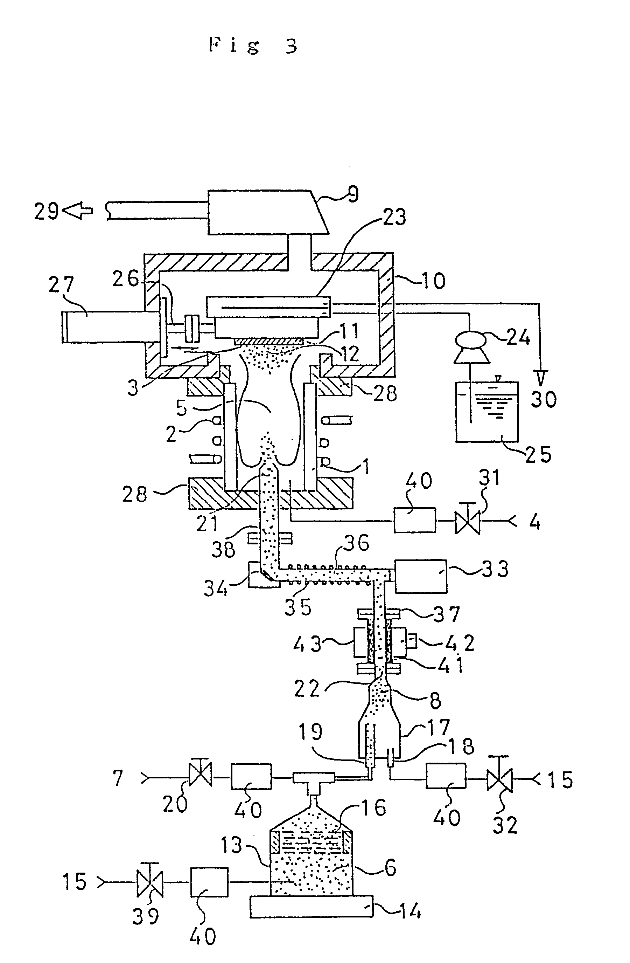

In the Figures, 1 represents a tubular glass vessel for containing a plasma flame, 2 is an induction coil for generating a high frequency electric field within the plasma vessel 1, and 3 is a thin film being deposited. 4 is a supply of gas, such as helium argon or nitrogen, which forms a plasma flame 5 within the plasma vessel 1, under the influence of an electric field generated by a current flowing in the coil 2. 6 represents a multi-element composite powder used as a raw material, which includes film forming elements. 7 is a supply of gas such as argon, ammonia, oxygen, hydrogen or a mixture of these, for mixing with and carrying the composite powder and 8 shows a suspension of the powder 6 in the gas from the supply 7. 9 is a vacuum pump, 10 a reduced pressure chamber and 11 a deposition substrate for receiving the deposited film 3. 12 shows an ionized vapour, derived from the powder 6 when the latter has entered the plasma flame 5. 13 is a container for holding the composite powder 6 prior to use; the container 13 is located on a vibrator 14, for moving and lifting the particles of the powder 6 up in the container 13 and into a stream of argon gas, which enters the container 13 from a supply 15. 16 is a filter, installed in the discharge port of the container 13, 17 a mixing chamber for mixing the powder 6 in argon, which enters the chamber 17 through an inlet 19, with a gas such as argon or ammonia, from the source 7, which enters the mixing chamber 17 via the inlet 18, to provide a suspension 8. 20 is a valve for adjusting the flow rate of the gas from supply 7, 21 is a nozzle for directing the suspension 8 into the plasma flame 5 and 22 is a discharge port from the mixing chamber 17. 23 is a cooling jig for cooling the desposition substrate 11, 24 a pump for cooling water and 25 a water tank. 26 is a thrust shaft for moving the deposition substrate 11, 27 is a cylinder for driving the shaft 26, 28 is a flange for retaining the plasma vessel 1 in contact with the reduced pressure chamber 10 and 29 is exhaust gas from the vacuum pump 9. 30 is a waste water discharge from the cooling jig 23, 31 a valve for adjusting the flow of gas from the supply 4 and 32 a valve for adjusting the pressure of the suspension 8 discharged from the mixing vessel 17. 33 is a laser for generating a laser beam (see Figures 2 and 3) and 34 is a reflection plate, for reflecting the laser beam (see Figure 3). 35 is an undulation coil having a magnetic pole for converging and guiding the laser beam, 36 is a glass guide tube for guiding the laser beam, 37 is an inlet for allowing the suspension 8 into the guide tube 36 and 38 is a discharge pipe for discharging the suspension 8 which has been heated in guide tube 36. 39 is a valve for adjusting the flow of argon gas into the container 13 from the supply 15, and 40 depicts heaters for heating the argon gas from the supplies 15 and 17. 41 is a conduit formed from a plastics resin material, which comprises a component of a sensor for measuring the quantity of powder 6 in the suspension 8 passing therethrough. The remainder of this sensor comprises a photo sensor 42 and an electrostatic measuring instrument 43.

## Example 1

An aqueous solution of caustic soda (NaOH) was added to and reacted with a multi-component aqueous salt solution containing iron (Fe), nickel (Ni) and aluminium (Al) ions in solution. The reaction produced a precipitated sludge comprising oxides, hydoxides and hydrated oxides of iron, nickel and aluminium. The sodium salt solution was decanted off and the precipitate washed with water, dried using a spray dryer, and, finally, comminuted into a fine powder.

This powder was then introduced into the container 13, of the apparatus illustrated in Figure 1 and the various gas supplies to this apparatus were turned on and the plasma flame 5 generated, within the glass vessel 1, by feeding a high frequency current through the coil 2. The gases employed in the apparatus were argon and nitrogen and the mixed oxide/hydroxide powder 6 was instantaneously vapourized, on entering the plasma flame 5. Carried by the plasma flame 5, the ionized vapour 12 impinges upon the substrate 11 (in this instance formed from quartz glass), which is maintained at a reduced temperature by the cooling jig 23. A multi-component composite synthetic film 3, comprising a mixed oxide of iron, nickel and aluminium, thus, is formed on the surface of the substrate. Throughout the procedure, the chamber surrounding the substrate, including the plasma vessel 1 was maintained at a reduced pressure of about 60mmHg.

The composite film obtained was analysed by X-ray techniques, which showed that the elemental ratio in the film was the same as that in the powder 6 employed as a raw material. It was also confirmed that the film 3 included a substantially uniform distribution of its component elements, and was in the form of a crystalline multi-component oxide film.

By moving the substrate 11 away from the nozzle 21, towards the tip of the plasma flame 5, a film formed from spherical particles could be obtained.

In the past, it has proven extremely difficult to produce multi-component or multi-element thin films where the components were introduced into the film under the same conditions and at the same time (both of which are pre-requisites for forming a highly uniform film.). Conversely, the method of the present invention allows all the components, which it is wished to include in a film, to be deposited in that film at the same time and under the same conditions, to thereby proivde a highly uniform film, on a molecular level. The method further provides for the synthesis of a thin film comprised of spherical particles.

## Example 2

A powdered multi-component oxide of nickel, aluminium and chromium was introduced into the container 13, of the apparatus shown in Figure 1, and argon gas was supplied into the apparatus via the various gas supplies 4, 7, 14 and 15. The composite powder 6 was instantaneously converted into a vapour phase plasma state, on entering the plasma flame 5 through the nozzle 21. In addition to argon, nitrogen was introduced through the supply 4, to provide the gas forming the plasma flame 5. As in example 1, a quartz glass substrate was employed and was maintained at a reduced temperature and a reduced pressure (of about 60mmHg). After a suitable period of operation, a three component composite film was deposited on the surface of the substrate 11.

After analysis using X-ray techniques it was determined that the nickel, aluminium and chromium were uniformly distributed in the film, on a molecular level. Moreover, the anaylsis revealed that the ratio of the elements forming the film was substantially the same as the ratio of elements in the powder 6 employed as a starting material.

From the above it can be understood that the composite film according to the present invention can be a multi-component composite oxide film of a type which it has been heretofore impossible to form, using vapour deposition and sputtering techniques. Thus, it is possible to form a film having an arbitrarily selected composition, by including the elements, which it is required to include in the film, in the starting material, in the same ratio as it is wished they should be present in the film. Accordingly, films suitable for use in various and diverse applications may be formed. These include industrial measurement techniques, the formation of storage elements, the formation of electronic semi-conductor elements, the manufacture of magnetic substantces, light reactive magnetic substances, insulating materials etc.

## Example 3

An aqueous solution including at least two or more ions, other than those derived from water, is reacted with an alkali solution in order to precipitate a mixed oxide of said ions. After the salt solution (typically sodium chloride where the starting material is a chloride solution and the alkali is caustic soda) has been removed and the precipitate dryed, the resulting powdered raw material 6 is placed into the container 13 of the apparatus shown in Figure 1. The container 1 is caused to vibrate by the vibrator 14 and argon gas is pumped into the container, from the supply 15 via the valve 39. The gas is heated by the heater 40, before it enters the container 13. The raw material 6, thus, becomes entrained in the argon and caused to float up inside the container 13. The filter 16 is arranged to allow only particles of 3μm or smaller to pass therethrough. Accordingly, a suspension of powder suspended in argon 8 leaves the container 13 in the direction of the mixing chamber 17. Before entering the mixing chamber 17, additional heated argon is added to the suspension 8, at a rate determined by the valve 32. The argon and powder mixture 8 enters the mixing chamber 17, via the inlet 19. Here, the suspension 8 is mixed with argon and/or ammonia, which enters the mixing chamber 17 through the inlet 18, from the gas supply 7, at a rate determined by the valve 20.

The photo sensor 42 and electrostatic sensor 43 are used to determine the ratio of powder 6, in the suspension 8, leaving the mixing chamber 17. The quantity of gases fed in from the sources 7 and 15 is adjusted in order to give the desired particle concentration through altering the setting of the valves 20, 32 and 39. The mixture 8 flows through the discharge pipe 38, into the plasma vessel 1 from the nozzle 21. A high frequency electric current is passed through the coil 2, wound on the outside of the plasma vessel 1, and argon and/or nitrogen is fed into the plasma vessel 1, from the supply 4. This gas is then formed into a high temperature plasma flame 5, by induction. The particles 6, entering this plasma via the nozzle 21, in the suspension 8, are immediately vapourized into an active state to form an ionized vapour 12, as they pass into the plasma flame 5. This ionized vapour 12 sprays onto the surface of the substrate 11, which is maintained at a reduced pressure (about 60mmHg) by the action of the vacuum pump 9. The substrate 11 is maintained at a reduced temperature by the cooling jig 23 and a multi-component composite film 3, in accordance with the present invention, is deposited onto the substrate 11.

**Example 4**

In this example, use is made of the apparatus as shown in Figure 2. A powdered raw material 6, of the type employed in example 3, is introduced into the container 13 and pumped out of the container 13, by the joint action of the vibrator 14 and the introduction of argon gas from a supply 15. The flow rate of the argon is adjusted using the valve 39 and the gas is heated by the heater 40. Only those particles 6 less than 3μm across are allowed to leave the container 13, by the filter 16. The mixture of particles 6 and argon, leaving the container 13, is blended with additional argon, supplied from the source 15 through the valve 32 and heater 40. The resulting suspension 8 then enters the mixing chamber 17, through the inlet 19, where it is mixed with argon and/or ammonia, from the gas supply 7; entering the mixing chamber 17, through the inlet 18, valve 20 and heater 40. The ratio of particles 6 to gas, in the suspension 8, is determined by the photo sensor 42 and the electrostatic sensor 43. The desired such ratio is achieved by adjusting the gas flow rates, using the valves 20, 32 and 39.

The suspension 8 passes from the tube 41 and into the entrance port 37 of the laser guide tube 36, where the particles 6, in the suspension 8, are heated by the effect of the laser beam produced by the laser 33. The heated suspension 8 then enters the plasma vessel 1, through the nozzle 21 of the discharge tube 38. As in the previous examples, a high frequency electric current is fed through the coil 2 and argon and/or nitrogen is passed into the plasma vessel 1 from a supply 4. A plasma flame 5, thus, is generated in the plasma vessel 1. As the particles 6 enter the plasma flame 5, from nozzle 21, they are immediately evaporated into an active vapour phase 12. This ionized vapour phase substance 12 is sprayed onto the surface of the substrate 11 which, as in the previous examples, is held on a cooling jig 23, in a reduced pressure chamber 10. A multi-component composite film 3 is thus formed on the substrate 11.

**Example 5**

The same procedure as described in example 4, is carried out using the apparatus shown in Figure 3. The effect of using the reflector plate 34, is to allow the mixture 8 to be heated to a higher temperature by the laser beam from the laser 33. This higher temperature is achieved because the laser guide tube 36 is longer, for a given size of apparatus.

From the above description, it should be appreciated that the process of the present invention allows the production of multi-component composite films, which include oxides, nitrogen containing compounds and a plurality of metals, whether in the form of oxides or not. The blending ratio of compounds and elements can be adjusted arbitrarily, in order to provide a film having a predetermined composition. Films in accordance with the present invention may be used in a variety of electronic devices, opto electronic devices and magneto electronic devices.

**Claims**

1. A method of forming on a substrate a composite film comprising two or more elements, wherein matter containing film forming elements is carried into a gaseous plasma, where said matter is converted into a vapour state, and is conveyed towards the substrate, to form the composite film thereon.

2. A method as claimed in claim 1, wherein the matter carried into the gaseous plasma is converted into an at least partially ionized vapour state in the gaseous plasma.

3. A method as claimed in either claim 1 or claim 2, wherein the matter comprises fine solid or liquid, preferably solid, particles, which are suspended in a gaseous substance for being conveyed into the plasma.

4. A method as claimed in claim 3, wherein said gaseous substance also provides at least one film forming element.

5. A method as claimed in any of the previous claims, wherein the gaseous plasma is formed from an inert gas, such as helium or argon, preferably in admixture with ammonia, oxygen, or hydrogen.

6. A method as claimed in any of the preceding claims, wherein the gaseous plasma is inductively generated by passing an oscillating, preferably radio frequency, electric field through the plasma forming gas.

7. A method as claimed in claim 6, wherein the radio frequency electric field is applied to the plasma forming gas by a coil arranged around a plasma containing vessel.

8. A method as claimed in any of the preceding claims, wherein the film forming elements are deposited on the substrate in proportion to their presence in the matter.

9. A method as claimed in claim 8, wherein ions or radicals present in the matter are preserved in the film after formation.

10. A method as claimed in any of the preceding claims, wherein the substances forming the matter are selected so that the film is formed as a solid solution, comprising a uniform distribution of film forming elements.

11. A method as claimed in any of the preceding claims, wherein the substrate is maintained at a lower temperature than the gaseous plasma and the gaseous plasma and substrate are maintained under conditions of reduced pressure.

12. A method as claimed in any of the preceding claims, wherein the matter includes elements selected from iron, nickel, aluminium, chronium, oxygen, nitrogen, arsenic, antimony, bismuth, selenium, tellurium, silicon, germanium, carbon, boron, and hydrogen.

13. A method as claimed in claim 12, wherein said elements are present in the form of oxides, nitrates, carbides or ammonium compounds.

14. A method as claimed in any of claims 4-13, wherein the gaseous substance includes a hydrocarbon, preferably methane, and the composite film formed thereby includes a carbide.

15. A method as claimed in any of the preceding claims, wherein the matter comprises fine solid particles produced by reacting an aqueous solution of a salt or salts, including at least two or more ions in addition to those from water, with an aqueous alkali solution, to precipitate the corresponding oxygen containing compounds which, thereafter, are dried, separated from the remaining salt solution and comminuted to provide a powder of said particles.

16. A method as claimed in claim 15, wherein the aqueous salt solution is a metal halide, preferably a metal chloride.

17. A method as claimed in any of the preceding claims, wherein the matter including the film forming elements is heated by laser light, prior to entering the electric field.

18. A composite film comprising two or more elements carried on a substrate, characterised in that the elements are substantially regularly distributed in the film in predetermined proportions.

19. A composite film as claimed in claim 18, wherein the film includes at least one non-metallic element.

20. A composite film as claimed in either of claims 18 or claim 19, wherein the elements forming the film are selected from iron, nickel, aluminium, chromium, oxygen, nitrogen, arsenic, antimony, bismuth, selenium, tellurium, silicon, germanium, carbon, boron and hydrogen.

21. A composite film as claimed in any of claims 18-20, wherein the film is a solid solution, which includes individual heteroatomic molecules or ions, is in the form of an extended array, or has a rigid crystalline structure.

22. A composite film as claimed in any of claims 18-21, wherein the film comprises a ceramic material.

23. A composite film comprising two or more elements carried on a substrate, characterised in that said film is formed by the method claimed in any one of claims 1-17.

24. A composite film as claimed in claim 18, characterised in that the film comprises a solid solution formed by a process in which an aqueous solution of a salt or salts, including at least two or more irons in addition to those from water, is reacted with an alkali to form a crystalline substance including said elements, said substance is purified, dried, comminuted into a particulate form, converted into an activated vapour state in a high temperature plasma and conveyed to a substrate by the plasma, where the vapourized substance condenses to form the composite film.

25. A composite film as claimed in claim 24, wherein said film is formed from spherical particles having a particle size of 1μm or less.

26. A method of forming a composite film as claimed in claim 1, characterised in that high frequency current is passed through a coil wound around a tubular glass vessel, high temperature plasma in a high density active state is produced in the vessel through inductive coupling and ionization of a gaseous substance, such as helium or argon passed into the vessel, an aqueous solution of a salt or salts, including at least two or more ions in addition to those from water, is reacted with an alkali to form a crystalline material including said elements, said substance is purified, dried, comminuted into a powder and mixed with argon gas, this mixture is further mixed with helium gas and/or argon gas and/or ammonia gas and/or oxygen gas and/or hydrogen gas, to provide a gaseous suspension of powder, which is passed into the plasma where the powder particles are converted into an activated vapour state, and in that said activated vapour is conveyed under reduced pressure to a substrate, where the activated vapour condenses to provide the composite film.

27. A method as claimed in claim 26, wherein the plasma forms a flame directed in an upwardly direction and the activated vapourized substance is blown into the plasma from a nozzle located near the lower portion of the plasma flame.

28. A method as claimed in claim 26, wherein the powder is placed in a container and vibrated by a vibrator mounted on the container, argon gas is passed into the container and the powder is lifted and floated upwardly towards a filter, those particles of the suspended powder having a particle size of 3μm or less are passed through the filter and out of the container, where said suspension of powder is directed into a mixing vessel, together with a gaseous substance, such as argon, argon and ammonia, or argon and oxygen, the quantity of powder and gases being controlled and adjusted so as to provide the desired component ratio in the product composite film.

29. A method as claimed in claim 26, wherein the dried crystalline substance is comminuted into a powdered form by a high temperature plasma atomizing process.

30. A method as claimed in claim 3 or 26, wherein the particles are in the form of a mist produced by passing high frequency vibrations through an aqueous solution of salt or salts, including at least two or more ions in addition to those from water, and preferably said particles are suspended in argon gas.

31. A method as claimed in claim 15, wherein the powder is dissolved in water and droplets of the resulting solution are suspended in argon gas.

32. A method as claimed in claim 26, wherein the gaseous substance is heated before it is mixed with the powder.

33. A method as claimed in claim 26, wherein the substrate is formed from a ceramic, glass, metal or composite material.

Fig 1

Fig 2

Fig 3